(19) Europäisches Patentamt
European Patent Office
Office européen des brevets

(11) Veröffentlichungsnummer: **0 023 613**
**B1**

# (12) EUROPÄISCHE PATENTSCHRIFT

(45) Veröffentlichungstag der Patentschrift: **18.04.84**

(51) Int. Cl.³: **B 41 M 5/12,** B 41 M 5/00

(21) Anmeldenummer: **80104036.1**

(22) Anmeldetag: **12.07.80**

## (54) Reaktionsdurchschreibepapier.

(30) Priorität: **26.07.79 DE 2930408**

(43) Veröffentlichungstag der Anmeldung: **11.02.81 Patentblatt 81/6**

(45) Bekanntmachung des Hinweises auf die Patenterteilung: **18.04.84 Patentblatt 84/16**

(84) Benannte Vertragsstaaten: **BE CH DE FR GB IT LI NL SE**

(56) Entgegenhaltungen:
**EP - A - 0 000 903**
**DE - A - 2 753 767**
**GB - A - 1 271 304**
**GB - A - 1 467 003**
**US - A - 2 757 085**
**US - A - 3 179 600**

(73) Patentinhaber: **BAYER AG, Konzernverwaltung RP Patentabteilung, D-5090 Leverkusen 1 Bayerwerk (DE)**

(72) Erfinder: **Dahm, Manfred, Dr., Am Falkenberg 29, D-5090 Leverkusen 31 (DE)**
Erfinder: **Jabs, Gert, Dr., Wingensieferkamp 25, D-5068 Odenthal (DE)**
Erfinder: **Wegner, Christian, Dr., Roggendorfstrasse 65E, D-5000 Köln 80 (DE)**

**EP 0 023 613 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Reaktionsdurchschreibepapier

Die Erfindung betrifft Reaktionsdurchschreibepapiere, die in einer Schicht farblose Farbstoffvorläufer in Mikrokapseln aus Polyharnstoff und Farbentwickler enthalten, wobei der Farbentwickler in dem wässrigen Reaktionsgemisch aus Polyisocyanat und Polyamin in situ hergestellt wurde.

Reaktionsdurchschreibepapiere sind bekannt (vgl. M. Gutcho, Capsule Technology and Microencapsulation, Noyes Data Corporation, 1972, Seiten 242-277; G. Baxter in Microencapsulation, Processes and Applications, herausgegeben von J.E. Vandegaer, Plenum Press, New York, London, Seiten 127-143).

Reaktionsdurchschreibepapiere bestehen vorzugsweise aus zwei oder mehreren lose aufeinandergelegten Papierblättern, wobei das jeweils obere auf der Rückseite eine Geberschicht und das jeweils untere auf der Vorderseite eine Nehmerschicht enthält. Es ist also jeweils eine Geberschicht und eine Nehmerschicht miteinander in Kontakt. Die Geberschicht enthält Mikrokapseln, deren Kernmaterial eine Lösung eines Farbbildners in einem organischen Lösungsmittel ist, und die Nehmerschicht enthält ein Material, das den Farbstoffbildner zum Farbstoff entwickelt.

Beim Beschreiben werden die Kapseln unter dem hohen Druck des Schreibgerätes zerstört und das auslaufende Kernmaterial trifft auf die Nehmerschicht, so dass eine Durchschrift entsteht. Die Nehmerschicht enthält in der Regel Bindemittel und Pigmente, z.B. aktive Absorbentien, wie Kaolin, Attapulgit, Montmorillonit, Bentonit, saure Bleicherde oder Phenolharze. Man kann z.B. auf der Geberschicht säure-aktivierbare Farbstoffe und in der Nehmerschicht sauer reagierende Komponenten einsetzen.

Eine Fortentwicklung dieser Reaktionsdurchschreibepapiere sind die «Einkomponenten»-Reaktionsdurchschreibepapiere. In diesen trägt eine Seite eines einzelnen Papierblattes den Farbvorläufer, im allgemeinen in Form von Mikrokapseln, und den Farbentwickler. Wenn nun Druck ausgeübt wird, z.B. durch eine Schreibmaschine oder ein anderes Schreibwerkzeug, wird die den Farbvorläufer enthaltende Kapsel aufgerissen, und der Farbvorläufer reagiert mit dem ihn umgebenden Farbentwickler (vgl. US-PS 2 730 456).

Werden zur Herstellung der «Einkomponenten»-Reaktionsdurchschreibepapiere Mikrokapseln verwendet, welche durch Komplexkoazervierung von Gelatine und Gummi-arabicum erhalten worden sind, dann hat die gesamte Oberfläche dieser Papiere einen Farbschleier.

Um den Farbschleier zu verringern, hat man beispielsweise eine Schutzschicht zwischen der Kapselschicht und der Entwicklerschicht angebracht, oder man hat die Kapseln mit einer zweiten Hülle versehen. Beispielsweise wird in der US-Patentschrift 3 179 600 ein Reaktionsdurchschreibepapier beschrieben, dessen Farbstoffvorläufer enthaltende Mikrokapseln im Prinzip auf folgende Weise erhalten werden: Der Farbstoffvorläufer wird durch Komplexkoazervierung in Gelatine/Gummi-arabicum eingekapselt, eine Traube aus mehreren Mikrokapseln noch einmal mit einer Koazervathülle versehen, dann auf dieser Kapseltraube ein Überzug aus Silikat durch Ausfällen eines Silicasols hergestellt, und schliesslich die Gelatine/Gummi-arabicum-Schicht durch Denaturieren mit Glutaraldehyd gehärtet. Bei der Abscheidung der Kapselwände wird somit kein polymeres Material neu gebildet, sondern es wird nur sein Aggregatzustand geändert, nämlich durch das Phasentrennungsverfahren. Um diese Phasentrennung zu erreichen, muss man von aussen in das System eingreifen, z.B. seinen pH ändern. Die Silikate werden nicht gleichzeitig mit der Hülle abgeschieden, sondern erst, nachdem die Hülle, sogar eine doppelte Hülle, praktisch fertig ist.

Gemäss der DE-AS 2 251 381 enthalten «Einkomponenten»-Reaktionsdurchschreibepapiere die Farbstoffvorläufer in Mikrokapseln mit Polyharnstoffwänden (aus Polyisocyanaten und Polyaminen). Polyharnstoffe aus Polyisocyanat und Wasser sind nach der Lehre dieser Offenlegungsschrift nicht ausreichend dicht, um die genannten Nachteile eines Farbschleiers auf dem Papier zu verhindern. Die Farbentwickler können ferner erst dann der Mikrokapseldispersion zugesetzt werden, wenn die Polyadditionsreaktion aus Polyisocyanat und Polyamin vollständig beendet ist.

Gegenstand der Erfindung sind Einkomponenten-Reaktionsdurchschreibepapiere bestehend aus Papier, auf dessen Oberfläche in einer Schicht angeordnet sind:

1. eine Lösung eines Farbstoffvorläufers, eingekapselt in Wände aus Polyharnstoff, der durch Umsetzung eines Polyisocyanats mit einem Polyamin und Wasser erhalten worden ist;
2. ein Entwickler, der mit dem Farbstoffvorläufer einen Farbstoff bildet, und der gleichzeitig mit der Umsetzung von Polyisocyanat und Polyamin in situ durch Temperatur- und/oder pH-Änderung aus wässrigen Lösungen basischer anorganischer Salze entstanden ist.

Bevorzugt bildet sich der Entwickler durch Temperatur oder pH-Änderung, und zwar durch Ausfällung von anorganischen Polyanionen im reagierenden Gemisch aus Polyisocyanat und Polyamin. Bevorzugt wird in situ ein Polysilikat oder ein Aluminiumoxidhydrat durch Ausfällung aus Kieselsol oder Aluminiumhydrat gebildet.

Das erhaltene Gemisch aus Mikrokapseln und Entwickler kann nach Zusatz üblicher Binder, Hilfs- und Zusatzstoffe direkt zur Papierbeschichtung verwendet werden.

Die erhaltenen Papiere sind reinweiss und ohne Farbschleier.

Erfindungsgemäss fällt der Entwickler in feinverteilter Form mit besonders aktiver, grosser Oberfläche an. Er steht in direktem Kontakt mit der Kapselwand. Deshalb kommt man mit wesentlich weniger Mikrokapseln aus.

Zur Herstellung der Mikrokapseln geeignete Isocyanate sind Diisocyanate, wie Xylylen-1,4-diiso-

cyanat, Xylylen-1,3-diisocyanat, Trimethylendiisocyanat, Hexamethylendiisocyanat, Propylen-1,2-diisocyanat, Butylen-1,2-diisocyanat, Ethylidendiisocyanat, Cyclohexyliden-1,2-diisocyanat, Cyclohexyliden-1,4-diisocyanat, Polyisocyanat-Vorpolymerisate, z.B. Anlagerungsprodukt von Hexamethylendiisocyanat und Hexantriol, Anlagerungsprodukt von 2,4-Toluylendiisocyanat mit Brenzkatechin, Anlagerungsprodukt von Toluylendiisocyanat mit Hexantriol, Anlagerungsprodukt von Toluylendiisocyanat mit Trimethylolpropan, Anlagerungsprodukt von Xylylendiisocyanat mit Trimethylolpropan.

Geeignete modifizierte aliphatische Isocyanate sind solche auf Basis von Hexamethylen-1,6-diisocyanat, m-Xylylendiisocyanat, 4,4'-Diisocyanat-dicyclohexylmethan bzw. Isophorondiisocyanat, die pro Molekül mindestens zwei funktionelle Isocyanatgruppen besitzen.

Geeignet sind ferner Polyisocyanate auf Grundlage von Derivaten des Hexamethylen-1,6-diisocyanats mit Biuretstruktur gemäss DE-AS 1 101 394, DE-AS 1 543 178, DE-OS 1 568 017, DE-OS 1 931 055.

Die Polyisocyanate können zusätzlich modifiziert werden durch Umsetzung mit di- und trifunktionellen Kettenverlängerern, z.B. Wasser, mit mehrfunktionellen Alkoholen, wie Ethandiol, Glycerin oder Trimethylolpropan, bzw. Carbonsäuren, wie Bernsteinsäure, Adipinsäure, Sebacinsäure, in Anteilen von 0,01 bis 0,5 Mol pro Isocyanat-Äquivalent.

Anstelle oder neben den Isocyanatgruppen können als reaktive Gruppen auch Carbodiimid-, Uretdion-, Uretonimin-, Uretdiondiimin-, 4-Imino-oxazolidinon-(2)-, $\beta$-Alkylen-propiolacton- bzw. Cyclobutandion-(1,3)-Gruppen vorhanden sein.

So sind beispielsweise einsetzbar Polyisocyanatopolyuretonimine, wie sie durch Carbodiimidisierung von Biuretgruppen enthaltendem Hexamethylen-1,6-diisocyanat mit Phosphor-organischen Katalysatoren entstehen, durch weitere Umsetzung primär gebildeter Carbodiimidgruppen mit Isocyanatgruppen zu Uretonimingruppen.

Weiterhin können diese Isocyanate in Mischung miteinander und anderen aliphatischen und aromatischen Isocyanaten verwendet werden.

Je nach Reaktionsbedingungen kann das resultierende modifizierte Polyisocyanat erhebliche Anteile an Oxadiazintrion, Triisocyanurat bzw. sym. Triazindionimin als Strukturelement enthalten. Auch solche Produkte eignen sich als Hüllenbildner.

Besonders geeignet sind Diisocyanate der Formel (I)

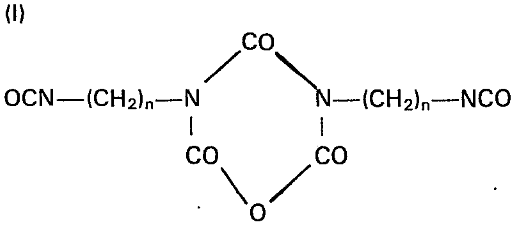 (I)

n = 3 bis 6.

Geeignete Diamine sind aliphatische, primäre oder sekundäre Diamine, z.B.: Ethylendiamin-(1,2), Bis(3-aminopropyl)-amin, Hydrazin, Hydrazinethanol-(2), Bis-(2-methylaminoethyl)-methylamin, 1,4-Diaminocyclohexan, 3-Amino-1-methyl-aminopropan, N-Hydroxy-ethyl-ethylendiamin, N-Methyl-bis-(3-aminopropyl)-amin, 1,4-Diamino-n-butan, 1,6-Diamino-n-hexan, Ethylen-(1,2)-diamin-N-ethyl-sulfonsäure (als Alkalisalz), 1-Amino-ethylethylendiamin-(1,2), Bis-N,N'-(aminoethyl)-ethylendiamin-(1,2). Hydrazin und seine Salze werden im vorliegenden Zusammenhang ebenfalls als Diamine angesprochen.

Beispiele für Farbstoffvorläufer sind Triphenylmethanverbindungen, Diphenylmethanverbindungen, Xanthenverbindungen, Thiazinverbindungen, Spiropyranverbindungen.

Insbesondere sind geeignet: Triphenylmethanverbindungen: 3,3-Bis-(p-dimethylaminophenyl)-6-dimethylaminophthalid («Kristallviolettlacton», nachstehend als «C.V.L.» bezeichnet) und 3,3-Bis-(p-dimethylaminophenyl)-phthalid («Malachitgrünlacton»); Diphenylmethanverbindungen: 4,4'-bisdimethylaminobenzhydrylbenzylether, N-Halogenphenylleucolamin, N-$\beta$-Naphthylleucolamin, N-2,4,5-Trichlorphenylleucolamin, N-2,4-Dichlorphenylleucolamin; Xanthenverbindungen: Rhodamin-$\beta$-anilinolactam, Rhodamin-$\beta$-(p-nitroanilin)-lactam, Rhodamin-$\beta$-(p-chloranilin)-lactam, 7-Dimethyl-amin-2-methoxyfluoran, 7-Diethylamin-3-methoxyfluoran, 7-Diethylamin-3-methylfluoran, 7-Diethylamin-3-chlorfluoran, 7-Diethylamin-3-chlor-2-methylfluoran, 7-Diethylamin-2,4-dimethylfluoran, 7-Diethylamin-2,3-dimethylfluoran, 7-Diethylamin-(3-acetylmethylamin)-fluoran, 7-Diethyl-amin-3-methylfluoran, 3,7-Diethylaminfluoran, 7-Diethylamino-3-(dibenzylamin)-fluoran, 7-Diethylamin-3-(methylbenzylamin)-fluoran, 7-Diethylamin-3-(Chlorethylmethylamino)-fluoran, 7-Diethylamin-3-(dichlorethylamin)-fluoran, 7-Diethylamin-3-(diethylamin)-fluoran; Thiazinverbindungen: N-Benzoylleucomethylenblau, o-Chlorbenzoylleucomethylenblau, p-Nitrolbenzoylleucomethylenblau; Spiroverbindungen: 3-Methyl-2,2'-spirobis-(benzo(f)-chromen).

Lösungsmittel, die diese Farbstoffvorläufer lösen, sind z.B. chloriertes Diphenyl, chloriertes Paraffin, Baumwollsamenöl, Erdnussöl, Siliconöl, Trikresylphosphat, Monochlorbenzol, ferner teilhydrierte Terphenyle, alkylierte Diphenyle, alkylierte Naphthaline, Arylether, Arylalkylether, höher alkyliertes Benzol und andere.

Häufig werden den Lösungsmitteln Verdünnungsmittel zugesetzt, wie beispielsweise Kerosin, n-Paraffine, Isoparaffine.

Zur Herstellung der Mikrokapseln werden zunächst die Farbstoffvorläufer und das Isocyanat in den genannten Lösungsmitteln gelöst und diese organische Phase in der kontinuierlichen wässrigen Phase, die Schutzkolloid und gegebenenfalls Emulgatoren enthalten kann, emulgiert. Zur Emulsion gibt man eine wässrige Polyaminlösung in stöchiometrischer Menge zum Polyisocyanat in der organischen Phase.

Zur Emulgierung und Stabilisierung der gebildeten Emulsion werden der wässrigen Phase Schutzkolloide und Emulgierhilfsmittel zugesetzt. Beispiele für solche als Schutzkolloide wirkende Produkte sind Carboxymethylcellulose, Gelatine und Polyvinylalkohol. Beispiele für Emulgatoren sind oxethyliertes

3-Benzylhydroxybiphenyl, Umsetzungsprodukte von Nonylphenol mit unterschiedlichen Mengen Ethylenoxid und Sorbitanfettsäureester.

Die Mikrokapseln können kontinuierlich oder diskontinuierlich hergestellt werden. Man verwendet im allgemeinen Dispergiergeräte, die ein Schergefälle erzeugen. Beispiele hierfür sind Blatt-, Korb-, Schnellrührer, Kolloidmühlen, Homogenisatoren, Ultraschalldispergatoren, Düsen, Stahldüsen, Supratonmaschinen. Die Stärke der Turbulenz beim Vermischen ist in erster Linie bestimmend für den Durchmesser der erhaltenen Mikrokapseln. Kapseln in der Grösse von 1 bis 2000 $\mu m$ können hergestellt werden. Bevorzugt sind Kapseln mit Durchmessern von 2 bis 20 $\mu m$. Die Kapseln agglomerieren nicht und haben eine enge Teilchengrössenverteilung. Das Gewichtsverhältnis von Kernmaterial zu Hüllenmaterial ist 50 bis 90 zu 50 bis 10.

Nach Zugabe der wässrigen Diaminlösung werden dem wässrigen Reaktionsgemisch nach dem erfindungsgemässen Verfahren wässrige Lösungen von Substanzen zugesetzt, die während der weiteren Abreaktion der Kapselwand in aktivierte Entwickler, die zur Farbreaktion mit den eingekapselten Farbvorläufern befähigt sind, überführt werden.

Erfindungsgemäss einzusetzende Substanzen sind vorzugsweise basische, anorganische Salze, die durch pH-Änderung des Reaktionsgemisches in unlösliche Polymersäuren oder Oxide überführt werden.

Beispiele für derartige anorganische Salze sind Zinkate, Stannate, Cuprate, Borate, Wolframate, Vanadate, Molybdate, Gemische aus Phosphaten mit den genannten Verbindungen, sowie bevorzugt Aluminate und Silikate.

Die Herstellung der aktivierten Form als Entwicklersubstanz geschieht beim erfindungsgemässen Verfahren dadurch, dass beim weiteren Fortschreiten der Kapselwandbildung der pH-Wert der wässrigen Phase gesenkt wird, wodurch in an und für sich bekannter Weise aus den basischen Salzen die Polymersäuren oder die Oxidhydrate ausgefällt werden. Diese Polymersäuren sowie die sauren Oxidhydrate, wie z.B. Kieselsäure oder Aluminiumoxid, sind als Farbentwickler bekannt. Zur schnelleren Ausreaktion und damit zum raschen Absenken des pH-Wertes kann das Reaktionsgemisch auf 60 bis 80°C erhitzt werden. Bei dieser Temperierung wird durch die Wasser/Isocyanat-Reaktion gleichzeitig Kohlendioxid gebildet, welches das Ausfällen der aktiven Entwicklersubstanz beschleunigt.

Vorzugsweise können daher beim erfindungsgemässen Verfahren Isocyanate mit Modifizierungsstrukturen eingesetzt werden, die zur Abgabe von $CO_2$ unter den genannten Reaktionsbedingungen befähigt sind. Als Beispiel seien Isocyanate mit Oxadiazintrionstruktur genannt.

Gegen Ende der Kapselwandreaktion können in die wässrige Phase zusätzlich Säuren gegeben werden, um den pH-Wert unter den Neutralpunkt zu senken und die aktiven Entwicklersubstanzen möglichst vollständig auszufällen.

Den Verlauf der kapselwandbildenden Polyaddition kann man anhand der Abreaktion der Isocyanatgruppen verfolgen.

Die nach Beendigung der Polyadditionsreaktion vorliegende Suspension aus Farbgeber enthaltenden Mikrokapseln und in situ hergestelltem Entwickler wird auf eine Trägerbahn aus Papier aufgestrichen. Die Suspension kann hierfür mit Bindemitteln, Abstandhaltern, die Farbreaktion beschleunigenden Mitteln, sowie weiteren Hilfs- und Zusatzmitteln versehen werden. Derartige Beschichtungskompositionen sind seit langem Stand der Technik (vgl. M. Gutcho, Capsule Technology and Microencapsulation, Noyes Data Corporation, 1972, Seiten 242-277).

Die homogenisierten, mit Binder und gegebenenfalls inerten Füllstoffen, wie Talkum oder Kaolin, versehenen Suspensionen aus Kapseln und Entwickler können manuell mit einem Blumendrahtrakel oder maschinell, beispielsweise mit einer Luftbürste, in Auftragsmengen von 4 bis 8 $g/m^2$ auf ein Trägermaterial aufgetragen werden. Die Beschichtung von Papieren ist beschrieben in den DE-OS 1 934 457 und 1 955 542.

Nehmerkomponenten sind ebenfalls in grosser Zahl bekannt geworden und ebenfalls in den DE-OS 1 934 457 und 1 955 542 beschrieben.

Es ist auch möglich, die wässrigen Suspensionen nach bekannten Verfahren zu trocknen, um freifliessende Pulver zu erhalten. Derartige Trockenverfahren, wie z.B. Gefriertrocknung, Sprühtrocknung und andere sind in grosser Zahl bekannt geworden und lassen sich auch zur Trocknung der erfindungsgemässen Suspension aus Kapseln und Entwickler einsetzen.

Die freifliessenden Pulver aus Kapseln und Entwickler lassen sich auch in organische Lösungsmittel aufnehmen und beispielsweise als Druckpaste zum flächigen Bedrucken von Papieren verwenden.

*Beispiel 1*

4,6 g Benzoylleukomethylenblau und 13,9 g Kristallviolettlacton werden in 393,2 g Diisopropylnaphthalin durch Erwärmen unter Rühren klar gelöst und zu dieser Lösung 98,3 g Isohexadecan und 90 g Oxadiazintriondiisocyanat zugesetzt. Diese organische Phase wird zu 1132,5 g einer 0,5 gew.%igen wässrigen Lösung von Polyvinylalkohol gegeben und mittels einer Ultraschallpfeife emulgiert, wobei die Emulsion eine Tröpfchengrösse von ca. 10 $\mu m$ erreicht. Dieser Emulsion wird unter Rühren eine 5,5%ige Aminlösung, bestehend aus 9,7 g Diethylentriamin und 5,1 g Ethylendiamin in 252,7 g entsalztem Wasser zugegeben. Nach der Aminzugabe wird der Kapselsuspension 4 kg 30%iges wässriges Kieselsol (Kieselsol 30 der Bayer AG) unter Rühren zugegeben. Anschliessend wird die Dispersion innerhalb 1,5 Stunden auf 60°C erwärmt und weitere 2 Stunden auf 60°C gehalten.

Während dieser Nachbehandlung wurde die Kapselwandbildung beendet, und der pH-Wert der Dispersion sank durch $CO_2$-Entwicklung und Abreaktion von pH 10,5 auf pH 8,0.

Nach Beendigung der Abreaktion wurden der Dispersion noch 2 l Wasser zugegeben.

*Beispiel 2*

Es wurde wie in Beispiel 1 verfahren mit dem Unterschied, dass als Polyisocyanat das Isocyanurat von Hexamethylendiisocyanat eingesetzt wurde. In diesem Fall wurde während der Abreaktion ein $CO_2$-Strom durch die Dispersion durchgeleitet, so dass die Slurry nach der Nachbehandlung über 2 Stunden bei 60°C einen pH-Wert von 7,0 erreichte.

*Beispiel 3*

Es wurde wie in Beispiel 1 verfahren mit dem Unterschied, dass nach der Aminzugabe der Suspension 4 kg 20%iges Kieselsol, das 5% Natriumaluminat sowie 1% Natriumzinkat enthielt, zugegeben wurde.

*Beispiel 4*

Die in den Beispielen 1 bis 3 hergestellten Dispersionen aus eingekapseltem Farbvorläufer und Entwickler wurden mit einem Drahtrakel (30 μm) auf ein Trägerpapier aufgestrichen und auf diese Weise ein Einkomponenten-Reaktionsdurchschreibepapier hergestellt. Das Beschichtungsgewicht betrug ca. 4 g/m², und der beschichtete Bogen war rein weiss, ohne erkennbaren Blauschleier.

Zur Ermittlung der Schreibleistung wurden auf das Einkomponenten-Reaktionspapier 8 weitere Papiere aufgelegt und mit einer elektrischen Schreibmaschine (Olympia Standard) bei konstanter Anschlagstärke eine Fläche von 4 x 4 cm so eng wie möglich mit dem Buchstaben «w» beschriftet. Die auf dem Reaktionspapier nunmehr sichtbare Schrift wurde auf ihre Schriftintensität geprüft, indem man den Verlust an Reflexion gegenüber nicht beschriftetem Papier mit einem Remissionsmessgerät (Elrephomat, Fa. Zeiss) ermittelt.

Es wurden folgende Schriftintensitäten gemessen:

| | Schriftintensität $\left(\frac{I-Io}{I} \cdot 100\right)$ |
|---|---|
| Beispiel 1 | 39,4 |
| Beispiel 2 | 36,4 |
| Beispiel 3 | 49,4 |

**Patentansprüche**

1. Einkomponentenreaktionsdurchschreibepapier, bestehend aus Papier, auf dessen Oberfläche in einer Schicht angeordnet sind:

1. eine Lösung eines Farbstoffvorläufers, eingekapselt in Wände aus Polyharnstoff, der durch Umsetzung eines Polyisocyanats mit einem Polyamin und Wasser erhalten worden ist;
2. ein Entwickler, der mit dem Farbstoffvorläufer einen Farbstoff bildet, und der gleichzeitig mit der Umsetzung von Polyisocyanat und Polyamin in situ durch Temperatur- und/oder pH-Änderung aus wässrigen Lösungen basischer anorganischer Salze entstanden ist.

2. Einkomponentenreaktionsdurchschreibepapier nach Anspruch 1, worin das basische anorganische Salz ein Silikat oder ein Aluminat ist.

**Claims**

1. One-component pressure-sensitive copying paper, consisting of paper, on the surface of which the following are arranged in one layer:

1. a solution of a dye precursor, encapsulated in walls of a polyurea which has been obtained by reacting a polyisocyanate with a polyamine and water;
2. a developer which forms a dye with the dye precursor and which has been formed in situ, at the same time as the reaction of the polyisocyanate with the polyamine, from aqueous solutions of basic inorganic salts by a change in temperature and/or pH.

2. One-component pressure-sensitive copying paper according to claim 1, in which the basic inorganic salt is a silicate or an aluminate.

**Revendications**

1. Papier carbone réactif à un composant, consistant en du papier sur la surface duquel sont agencés en une couche:

1. une solution de précurseur de colorant, encapsulée dans des parois en polyurée obtenue par réaction d'un polyisocyanate avec une polyamine et de l'eau,
2. un révélateur, lequel forme avec le précurseur de colorant un colorant et qui est obtenu, simultanément avec la réaction du polyisocyanate et de la polyamine in situ, par variation de la température et/ou du pH à partir de solutions aqueuses de sels minéraux basiques.

2. Papier carbone réactif à un composant selon la revendication 1, dans lequel le sel minéral basique est un silicate ou un aluminate.